(19) Europäisches Patentamt / European Patent Office / Office européen des brevets

(11) **EP 2 573 590 A1**

(12) **EUROPEAN PATENT APPLICATION**
published in accordance with Art. 153(4) EPC

(43) Date of publication:
**27.03.2013 Bulletin 2013/13**

(51) Int Cl.:
***G01T 3/06*** *(2006.01)*          ***C09K 11/00*** *(2006.01)*
***C09K 11/64*** *(2006.01)*          ***G01T 1/17*** *(2006.01)*
***G01T 3/00*** *(2006.01)*

(21) Application number: **11783585.0**

(22) Date of filing: **18.05.2011**

(86) International application number:
**PCT/JP2011/061440**

(87) International publication number:
**WO 2011/145651 (24.11.2011 Gazette 2011/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2010 JP 2010277473**
**18.05.2010 JP 2010113938**

(71) Applicants:
- **Tokuyama Corporation**
  **Shunan-shi, Yamaguchi-ken 745-8648 (JP)**
- **National University Corporation Nagoya University**
  **Nagoya-shi, Aichi 464-8601 (JP)**
- **Tohoku University**
  **Sendai-shi, Miyagi 980-8577 (JP)**

(72) Inventors:
- **WATANABE, Kenichi**
  **Nagoya-shi**
  **Aichi 464-8601 (JP)**
- **YAMAZAKI, Atsushi**
  **Nagoya-shi**
  **Aichi 464-8601 (JP)**
- **URITANI, Akira**
  **Nagoya-shi**
  **Aichi 464-8601 (JP)**
- **KONDO, Yoshiyuki**
  **Nagoya-shi**
  **Aichi 464-8601 (JP)**

- **KAWAGUCHI, Noriaki**
  **Shunan-shi**
  **Yamaguchi 745-8648 (JP)**
- **FUKUDA, Kentaro**
  **Shunan-shi**
  **Yamaguchi 745-8648 (JP)**
- **SUYAMA, Toshihisa**
  **Shunan-shi**
  **Yamaguchi 745-8648 (JP)**
- **YOSHIKAWA, Akira**
  **Sendai-shi**
  **Miyagi 980-8577 (JP)**
- **YANAGIDA, Takayuki**
  **Sendai-shi**
  **Miyagi 980-8577 (JP)**
- **YOKOTA, Yui**
  **Sendai-shi**
  **Miyagi 980-8577 (JP)**
- **IGUCHI, Tetsuo**
  **Nagoya-shi**
  **Aichi 464-8601 (JP)**

(74) Representative: **Schlief, Thomas P.**
**Patentanwälte**
**Canzler & Bergmeier**
**Friedrich-Ebert-Straße 84**
**85055 Ingolstadt (DE)**

(54) **NEUTRON BEAM DETECTOR, NEUTRON BEAM DETECTION SCINTILLATOR, AND METHOD FOR DISCRIMINATION BETWEEN NEUTRON BEAM AND   BEAM**

(57)    Disclosed are: a neutron beam detector which comprises a material having low deliquescent properties and can discriminate between a neutron beam and a γ beam; a neutron beam detection scintillator; and a method for discriminating between a neutron beam and a γ beam. Specifically disclosed are: a neutron beam detection scintillator for use in the discrimination between a neutron beam and a γ beam based on the difference in waveforms of light detection signals, and which comprises Ce-containing LiCaAlF6 single crystals; a neutron beam detector which has a function of discriminating between a neutron beam and a γ beam based on the difference in waveforms of light detection signals from a neutron beam detection scintillator, and which is characterized by using a neutron beam detection scintillator comprising Ce-containing LiCaAlF6 single crystals as a

EP 2 573 590 A1

neutron beam detection scintillator; and a method for discriminating between a neutron beam and a γ beam.

## FIG. 5

**Description**

**Technical Field**

The present invention relates to a neutron radiation detector and specifically relates to a neutron radiation detector that discriminates light emission caused by neutron radiation and light emission caused by $\gamma$ radiation based on a difference in pulse shape between photodetection signals, using a predetermined Ce-containing colquiriite-type fluoride single crystal as a neutron radiation detection scintillator.

**Background Art**

A scintillator is a substance that upon being hit by radiation such as $\alpha$ radiation, $\beta$ radiation, $\gamma$ radiation, X radiation or neutron radiation, absorbs the radiation and emits light. The scintillator is used for radiation detection in combination with a photodetector such as a photomultiplier tube. There are a variety of scintillators depending on the radiation types and/or the purpose of use, and as the scintillators, there are inorganic crystals such as $Bi_4Ge_3O_{12}$ and $Gd_2SiO_5$:Ce, organic crystals such as anthracene, and high polymer substances such as organic phosphor-containing polystyrene and polyvinyl toluene, and there are also liquid scintillators and gas scintillators.

Radiation detectors using scintillators are applied in a variety of fields, e.g., the medical field such as tomography, the industrial field such as nondestructive testing, the security field such as inspection of personal belongings and the scientific field such as high-energy physics. In particular, neutron radiation detectors are beginning to be deployed mainly in the U.S. in order to prevent illegal inflow of nuclear substances that generate neutron radiation by means of spontaneous fission, and a further increase in demand for the neutron radiation detectors is expected.

However, in conventional neutron radiation detection, not radiation detectors using a scintillator, but $^3$He gas-used neutron radiation detectors that utilizes $^3$He(n, p)T reaction between $^3$He and neutron radiation are mainly used. Neutron radiation are named depending on their energies, and classified into, e.g., thermal neutrons (approximately 0.025 eV), epithermal neutrons (approximately 1 eV), slow neutrons (0.03 to 100 eV), intermediate neutrons (0.1 to 500 keV), fast neutrons (500 keV or more). The probability of occurrence of $^3$He(n, p)T reaction is significantly low in the case of fast neutrons with high energy and $^3$He gas-used neutron radiation detectors have low detection sensitivity, and thus, main detection targets for the neutron radiation detectors are thermal neutron radiation with low energy. For detecting fast neutrons, a method in which fast neutrons are detected after the fast neutrons are moderated to thermal neutrons using a moderator of, e.g., polyethylene is used, and for example, a rem counter or a Bonner sphere spectrometer in which a $^3$He-used neutron radiation detector unit is covered by a spherical polyethylene moderator is used.

As another method for detecting fast neutrons, there is a method in which fast neutrons are detected without moderation using a fast neutron radiation detection scintillator utilizing recoil protons generated when neutron radiation collides with hydrogen atoms, such as an organic liquid scintillator or a plastic scintillator, as a scintillator; however, this method is not suitable for detection of thermal neutrons with low energy, and thus, $^3$He gas-used neutron radiation detectors capable of detecting neutrons ranging from thermal neutrons to fast neutrons in combination with a moderator are normally used.

Furthermore, neutron radiation easily generates prompt $\gamma$ radiation as a result of causing a radiation capture reaction with many kinds of substances, and thus, neutron detectors are highly likely to be used in situations in which $\gamma$ radiation is generated. Therefore, neutron radiation detectors are demanded to have low sensitivity to $\gamma$ radiation. $^3$He gas-used neutron radiation detectors are excellent also in terms of its low sensitivity to $\gamma$ radiation compared to neutron detectors using a solid neutron radiation detection scintillator because their detection units are gases, which have a low density compared to solids.

However, $^3$He gas is a rare raw material that originates from hydrogen bombs and has been supplied mainly from the U.S., and there is a demand for substitute techniques for hydrogen bombs because of a recent price increase due to no new hydrogen bombs being manufactured any longer. For the substitute techniques, a detector using a solid neutron radiation detection scintillator is one of good candidates.

Solid neutron radiation detection scintillators, which are mainly ones containing $^6$Li, are used for detecting scintillation light resulting from $\alpha$ radiation generated by $^6$Li(n, $\alpha$)$^3$H reaction between $^6$Li and neutron radiation. The probability of occurrence of $^6$Li(n, $\alpha$)$^3$H reaction is significantly low for fast neutrons as with $^3$He(n, p)T reaction, and thus, as with $^3$He gas-used neutron radiation detectors, a main detection target thereof is thermal neutron radiation with low energy. Accordingly, also as with $^3$He gas-used neutron radiation detectors, solid neutron radiation detection scintillators can detect a wide energy range of neutron radiation from thermal neutrons to fast neutrons in combination of a moderator.

However, $^6$Li-used solid neutron radiation detection scintillators have the drawback of easily emitting light not only when irradiated with neutron radiation, but also when irradiated with $\gamma$ radiation. As described above, neutron radiation causes a radiation capture reaction with many kinds of substances and easily generates prompt $\gamma$ radiation,

and neutron detectors are highly likely to be used in situations in which $\gamma$ radiation is generated; however, if a neutron radiation detection scintillator generates light in response to $\gamma$ radiation, resulting in erroneous detection, making it impossible to detect neutron radiation only. Thus, solid neutron radiation detection scintillators cannot be used in a high-dose $\gamma$ radiation field.

Also, for epithermal neutrons with energy higher than that of thermal neutrons, $^6$Li-used solid neutron radiation detection scintillators are required to be a large crystal for ensuring detection efficiency in order to detect epithermal neutrons without moderation because solid neutron radiation detection scintillators have a small absorption cross-section. An increase in size of a crystal relatively increases the sensitivity to $\gamma$ radiation, whereby the effect of $\gamma$ radiation becomes a problem, resulting in difficulty to detect epithermal neutrons even in a site that is not a high-dose $\gamma$ radiation field.

According to the above, light emission caused by $\gamma$ radiation is a large problem for neutron radiation detection scintillators, and it is important for a $^6$Li-used neutron radiation detection scintillator to have an ability to distinguish between light emission caused by neutron radiation and light emission caused by $\gamma$ radiation (discrimination ability).

Although the aforementioned fast neutron radiation detection scintillators utilizing recoil protons have sensitivity to $\gamma$ radiation and thus have a problem of prompt $\gamma$ radiation as with $^6$Li-used solid neutron radiation detection scintillators, a neutron radiation detector using a fast neutron radiation detection scintillator discriminates between light emission caused by neutron radiation and light emission caused by $\gamma$ radiation based on a difference in pulse shape between photodetection signals from a photodetector, such as a photomultiplier tube, that receives light emitted from the scintillator (Non Patent Literature 1). Hereinafter, discrimination between light emission caused by neutron radiation and light emission caused by $\gamma$ radiation based on a difference in pulse shape between photodetection signals from a photodetector is also referred to as "pulse shape discrimination". This is based on the fact that fast electrons generated from $\gamma$ radiation and recoil protons generated from neutrons have stopping powers that are largely different from each other and also have different emission processes and thus have different periods of decay, resulting in a difference in pulse shape between photodetection signals from a photodetector. However, as mentioned above, the scintillators are not suitable for detection of neutron radiation with low energy such as thermal neutrons, and detection targets for the scintillators are limited to fast neutrons.

$^6$Li-used neutron radiation detection scintillators have not achieved pulse shape discrimination between neutron radiation and $\gamma$ radiation except some materials described below, development for a material with a high $\alpha/\beta$ ratio and a low effective atomic number has been conducted.

An $\alpha/\beta$ ratio can be calculated by dividing an amount of light emitted by $\alpha$ radiation excitation of a scintillator (light yield (number of photons in scintillation light per unit energy of radiation used for excitation)) by an amount of light emitted by $\gamma$ radiation excitation, and as the $\alpha/\beta$ ratio is higher, the amount of light emitted by $\gamma$ radiation relative to the amount of light emitted by neutron radiation is smaller. Accordingly, setting a threshold value for an amount of emitted light in a neutron radiation detector at the time of detection enables removal of a photodetection signal for light with a small emission amount (mainly light emitted by $\gamma$ radiation excitation) from detected photodetection signals, enabling reduction in the effect of $\gamma$ radiation.

Also, an effective atomic number is a value that can be calculated from a composition of a compound and the atomic numbers of constituent elements, and as the effective atomic number is higher, the sensitivity to $\gamma$ radiation is higher, and thus, the effective atomic number is lowered to provide low sensitivity to $\gamma$ radiation to reduce the frequency of light emissions caused by $\gamma$ radiation excitation, whereby signals according to light emissions caused by $\gamma$ radiation, which are contained in photodetection signals from a photodetector, can be reduced, enabling reduction in the effect of $\gamma$ radiation.

A scintillator including a predetermined Ce-containing colquiriite-type fluoride single crystal, in particular, a Ce-containing LiCaAlF$_6$ single crystal, which is proposed by the present inventors, includes light elements having low sensitivity to $\gamma$ radiation, and has a low effective atomic number and is capable of discriminating between photodetection signals according to light emitted by neutron radiation and other signals based on their pulse height values (Patent Literature 1). However, where the energy of $\gamma$ radiation is high, the pulse height value of light emitted by the $\gamma$ radiation is also increased, and thus, it can be expected that discrimination based on the pulse height values becomes difficult.

For $^6$Li-used neutron radiation detection scintillators capable of pulse shape discrimination, e.g., LiBaF$_3$ crystals (Non Patent Literature 2) and chloride crystals and bromide crystals with a crystal structure called elpasolite and (Non Patent Literature 3) have been reported. These crystals are used as a scintillator that performs light emission caused by core-level energy transition called core-valence luminescence to perform pulse shape discrimination.

Core-valence luminescence is a phenomenon in which light is emitted not by $\alpha$ radiation (generated by a nuclear reaction between neutron radiation and $^6$Li) but by $\gamma$ radiation, and fluorescence lifetime components of light emitted by neutron radiation and $\gamma$ radiation are differentiated accordingly and using the difference, pulse shape discrimination is performed.

However, these crystals have the drawbacks of, e.g., having a significantly large deliquescent property and difficulty in handling, and are not widely and generally used currently.

Meanwhile, $^6$Li glass scintillators, which are commercially available neutron scintillators, are excellent in small deliquescent property, but has a large effect of $\gamma$ radiation compared to $^3$He gas-type detectors and have limited uses. Furthermore, according to the present inventors' study, $^6$Li glass scintillators were unable to conduct pulse shape discrimination.

[Citation List]

[Patent Literature]

[Patent Literature 1]

International Publication No. WO2009/119378

[Non Patent Literature]

[Non Patent Literature 1]

S.D. Jastaniah et al, "Digital techniques for n/$\gamma$ pulse shape discrimination and capture-gated neutron spectroscopy using liquid scintillators," Nuclear Instruments and Methods in Physics Research A, Accelerators, Spectrometers, Detectors and Associated Equipment, Volume 517 (2004) 202-210

[Non Patent Literature 2]

C. W. E. van Eijk et al, "LiBaF3, a thermal neutron scintillator with optimal n-$\gamma$ discrimination," Nuclear Instruments and Methods in Physics Research A, 374 (1996) 197-201.

[Non Patent Literature 3]

C. W. E. van Eijk et al, "Development of Elpasolite and Monoclinic Thermal Neutron Scintillators," 2005 IEEE Nuclear Science Symposium Conference Record, N12-3.

## Summary of Invention

### Technical Problem

An object of the present invention is to provide a neutron radiation detector including a material with a small deliquescent property and capable of discrimination between neutron radiation and $\gamma$ radiation, a neutron radiation detection scintillator and a method for discriminating between neutron radiation and $\gamma$ radiation.

### Solution to Problem

As a result of a diligent study for a neutron radiation detector with a small deliquescent property and capable of discrimination between neutron radiation and $\gamma$ radiation, the present inventors found that use of a predetermined Ce-containing colquiriite-type fluoride single crystal as a neutron radiation detection scintillator results in differentiation in fluorescence lifetime between light emission caused by neutrons and light emission caused by $\gamma$ radiation and thus can perform pulse shape discrimination, and accordingly, the present invention has been completed.

In other words, the present invention provides: a neutron radiation detection scintillator for discrimination between neutron radiation and $\gamma$ radiation based on a difference in pulse shape between photodetection signals, the neutron radiation detection scintillator including a single crystal of a compound represented by the formula, $LiM^1M^2F_6$ (wherein $M^1$ is at least one type of alkaline-earth metal element selected from Mg, Ca, Sr and Ba and $M^2$ is at least one type of metal element selected from Al, Sc, Ti, Cr, Fe and Ga); a neutron radiation detector having a function that discriminates between neutron radiation and $\gamma$ radiation based on a difference in pulse shape between photodetection signals from a neutron radiation detection scintillator in which a neutron radiation detection scintillator including a single crystal of a compound represented by the above formula is used as the neutron radiation detection scintillator; and a method for discriminating between neutron radiation and $\gamma$ radiation.

### Advantageous Effects of Invention

A predetermined Ce-containing colquiriite-type fluoride single crystal, in particular, a Ce-containing $LiCaAlF_6$

single crystal, according to the present invention is a neutron radiation detection scintillator having a small deliquescent property, a low effective atomic number and a low frequency of light emissions caused by γ radiation and capable of pulse shape discrimination between neutron radiation and γ radiation. Furthermore, a method for pulse shape discrimination between photodetection signals using a combination of the scintillator and a photodetector such as a photomultiplier tube is favorable for neutron radiation detection with a reduced effect of γ radiation, and a neutron radiation detector including a Ce-containing LiCaAlF$_6$ single crystal, a photodetector and a pulse shape discrimination mechanism for photodetection signals is favorable for use as a neutron radiation detector with a reduced effect of γ radiation. Furthermore, where the energy of γ radiation is high, discrimination based on pulse height values is difficult; however, pulse shape discrimination or a combination of pulse shape height-based discrimination and pulse shape discrimination enable removal of the effect of γ radiation, and thus, where the energy of γ radiation is high, the neutron radiation detector is also favorable for use as a neutron radiation detector with a reduced effect of γ radiation.

Also, when epithermal neutrons having energy higher than that of thermal neutrons are detected using a neutron radiation detection scintillator whose main detection target is thermal neutrons, the absorption cross-sectional area of the scintillator becomes small and thus, a large-size crystal is required for ensuring detection efficiency. An increase in size of a crystal relatively increases the sensitivity to γ radiation, whereby the effect of γ radiation becomes a problem. However, if neutron-γ radiation discrimination using, e.g., a Ce-containing LiCaAlF$_6$ single crystal, which originally has a small effective atomic number and a low frequency of light emissions caused by γ radiation as a neutron radiation detection scintillator, is enabled, epithermal neutrons that are difficult to be detected can be detected efficiently with the effect of γ radiation removed. Furthermore, thermal neutrons can be detected in a high-dose γ radiation field in which use of a scintillator is conventionally considered difficult.

**Brief Description of Drawings**

Figure 1      is a schematic diagram of a manufacturing apparatus using a micro-pulling-down method for a crystal used for a scintillator according to the present invention.

Figure 2      is a schematic diagram illustrating a neutron radiation detection unit in a neutron radiation detector according to the present invention.

Figure 3      is a schematic diagram illustrating a system configuration of a neutron radiation detector faccording to the present invention where an analog circuit is used.

Figure 4      is a schematic diagram illustrating a system configuration of a neutron radiation detector according to the present invention where digital pulse shape processing is used.

Figure 5      is a two-dimensional plot of rise time and pulse height during neutron radiation irradiation by a neutron radiation detector according to the present invention.

Figure 6      is a two-dimensional plot of rise time and pulse height during γ radiation irradiation by a neutron radiation detector according to the present invention.

Figure 7      is a graph of pulse height distribution spectrums during neutron radiation irradiation by a neutron radiation detector according to the present invention.

Figure 8      is a two-dimensional plot of rise time and pulse height during neutron radiation irradiation where lithium glass is used for a neutron detection scintillator.

Figure 9      illustrates fluorescence decay curves of light emissions during γ radiation and neutron radiation irradiation by a neutron radiation detector according to the present invention.

Figure 10     is a two-dimensional plot indicating a ratio of a fast component light emission amount and a total light emission amount during γ radiation and neutron radiation irradiations, obtained by a neutron radiation detector according to the present invention.

Figure 11     is a graph of pulse height distribution spectrums during neutron radiation irradiation by a neutron radiation detector according to the present invention.

**Description of Embodiments**

A neutron radiation detection scintillator for discrimination between neutron radiation and γ radiation based on a difference in pulse shape between photodetection signals, according to the present invention includes a single crystal of a compound represented by the formula, $LiM^1M^2F_6$ (wherein $M^1$ is at least one type of alkaline-earth metal element selected from Mg, Ca, Sr and Ba and $M^2$ is at least one type of metal element selected from Al, Sc, Ti, Cr, Fe and Ga).

A crystal of the compound represented by the formula, $LiM^1M^2F_6$ (wherein $M^1$ is at least one type of alkaline-earth metal element selected from Mg, Ca, Sr and Ba and $M^2$ is at least one type of metal element selected from Al, Sc, Ti, Cr, Fe and Ga) is referred to as a colquiriite-type fluoride crystal. Colquiriite is naturally-occurring $LiCaAlF_6$, and a colquiriite-type fluoride crystal is a crystal of a fluoride having a crystal structure similar to that of colquiriite. A colquiriite-type fluoride crystal is a hexagonal crystal belonging to the space group P31 c, and can easily be identified by a powder X-ray diffraction technique.

The below description will be provided taking an $LiCaAlF_6$ single crystal in which $M^1$ is Ca and $M^2$ is Al from among predetermined colquiriite-type fluoride single crystals represented by the above formula, as an example.

In the present invention, a Ce-containing $LiCaAlF_6$ single crystal contains a $^6Li$ element. Natural Li normally has a $^6Li$ content percentage of 7.6 mol%, and a $^6Li$ content in a Ce-containing $LiCaAlF_6$ single crystal is 0.73 atom/nm$^3$ even if no special adjustment method is employed. Here, a $^6Li$ content percentage refers to a percentage of the $^6Li$ isotope in all of Li elements, and a $^6Li$ content refers to a number of $^6Li$ elements contained per 1 nm$^3$ of a scintillator. Incident neutrons cause a nuclear reaction with $^6Li$ and generate α radiation. Accordingly, the $^6Li$ content affects the sensitivity to neutron radiation, and as the $^6Li$ content is larger, the sensitivity to neutron radiation is enhanced more.

Where the $^6Li$ content percentage is low, it is necessary to make the crystal have a large thickness in order to obtain sufficient sensitivity to neutron radiation; however, the single crystal according to the present invention has high transparency, enabling reduction in decay of emitted light reaching a photodetector, which is caused by the thickness of the crystal, and thus, a Ce-containing $LiCaAlF_6$ single crystal having a low $^6Li$ content, such as that using a general raw material having a natural isotopic ratio as a starting raw material can also be used as a neutron detection scintillator.

The $^6Li$ content can be adjusted as appropriate by adjusting a $^6Li$ content percentage in, e.g., LiF used as a raw material for Li. Examples of a method for adjusting a $^6Li$ content percentage include an adjustment method in which the $^6Li$ isotopes are concentrated so as to have a desired $^6Li$ content percentage using a general raw material having a natural isotopic ratio as a starting raw material and an adjustment method in which a concentrated raw material with $^6Li$ concentrated to a desired $^6Li$ content percentage or more is provided in advance and the concentrated raw material and the general raw material are mixed.

In the present invention, it is preferable that the $^6Li$ content be no less than 1.1 atom/nm$^3$ because a used amount of a Ce-containing $LiCaAlF_6$ single crystal can be reduced. Where the $^6Li$ content is no less than 1.1 atom/nm$^3$, the Ce-containing $LiCaAlF_6$ single crystal has sufficient sensitivity to neutron radiation even though the used amount of the Ce-containing $LiCaAlF_6$ single crystal is small. The content can be achieved without use of a large amount of Li raw material with the $^6Li$ content percentage specially increased, enabling provision of a neutron radiation detection scintillator at a low cost. Furthermore, in order to further enhance the sensitivity to neutron radiation, it is particularly preferable that the $^6Li$ content be no less than 2.9 atom/nm$^3$.

Meanwhile, the $^6Li$ content has an upper limit of 10 atom/nm$^3$. The $^6Li$ content in the Ce-containing $LiCaAlF_6$ single crystal is a calculated maximum of approximately 10 atom/nm$^3$, and no higher $^6Li$ content can be obtained.

The above $^6Li$ content can be obtained by expression [1] below.

$$^6Li \text{ content} = A \times C \times \rho \times 10^{-23} / M \, [1]$$

(wherein $\rho$ is a density of a Ce-containing $LiCaAlF_6$ single crystal [g/cm$^3$], M is a molecular weight of the Ce-containing $LiCaAlF_6$ [g/mol], C is the $^6Li$ content percentage in Li elements [mol%] and A is Avogadro's number, [6.02 x 10$^{23}$]).

Upon α radiation, which is secondary radiation described above, hitting the scintillator, numeral electron-hole pairs are generated in the scintillator, light emission occurs when some of the electron-hole pairs are recombined via Ce. In the case of Ce, light emission occurs due to 5d-4f transition caused by electron transition from the 5d level to the 4f level. Light emission occurring due to 5d-4f transition of Ce has a particularly short lifetime, and accordingly, a scintillator that is excellent in rapid responsiveness can be obtained.

Although the range of the Ce content in the $LiCaAlF_6$ single crystal is not specifically limited, a Ce content of 0.001 to 0.16 mol% relative to $LiCaAlF_6$ is preferable. In a Ce-containing $LiCaAlF_6$ single crystal, as the Ce content is lower, the amount of light emitted upon radiation irradiation is lower, while as the Ce content is higher, the amount of light emitted upon radiation irradiation is higher. In particular, a Ce content of no less than 0.001 mol% relative to $LiCaAlF_6$

facilitates detection in a photomultiplier tube, and as the content is increased, detection becomes easier. However, where the Ce content exceeds 0.16 mol% relative to LiCaAlF$_6$, white turbidity and/or cracking occurs, resulting in difficulty in the single crystal growth.

Although a mode of existence of Ce contained in a crystal is not known, it can be guessed that Ce exists in a crystal lattice and/or by replacing some of Ca and Al atoms, which are elements included in the crystal lattice.

When making Ce be contained during a process of manufacturing an LiCaAlF$_6$ single crystal, which will be described later, a segregation phenomenon of Ce may be observed in the crystal. Even where such segregation phenomenon is observed, an LiCaAlF$_6$ single crystal having a desired content of Ce can easily be obtained if an effective segregation coefficient (k) is calculated in advance and the Ce content in raw materials is adjusted according to expression [2] below.

$$C_s = kC_0 (1 - g)^{k-1} \quad [2]$$

(wherein C$_s$ is a Ce content in a single crystal [mol%(Ce/Ca)], k is an effective segregation coefficient, C$_0$ is a Ce content in raw materials [mol%(Ce/Ca)], g is a solidification ratio, that is a ratio of weight of the resulting single crystal relative to the total weight of the raw materials).

For the effective segregation coefficient, a value described in literatures (for example, Kiyoshi Shimamura et al, "Growth of Ce-doped LiCaAlF6 and LiS-rAlF6 single crystals by the Czochralski technique under CF4 atmosphere," Journal of Crystal Growth 211 (2000) 302-307) can be employed. However, the effective segregation coefficient varies also depending on the growth method, and according to the present inventor's study, an effective segregation coefficient of Ce relative to LiCaAlF$_6$ is 0.02 in the case of the Czochralski method, and 0.04 in the case of the micro-pulling-down method.

Furthermore, the Ce content in an actual crystal can be investigated by means of a general element analysis method (for example, ICP mass spectrometry or ICP emission spectrometry).

The Ce-containing LiCaAlF$_6$ is a single crystal, and thus, almost no loss due to, e.g., non-radiative transition attributed to defects in the lattice and/or dissipation of scintillation light at crystal grain boundaries occurs, enabling provision of a scintillator for neutrons that has high emission intensity.

The Ce-containing LiCaAlF$_6$ single crystal is a colorless or slightly colored transparent crystal, and exhibits an excellent transmission property for scintillation light. Also, the Ce-containing LiCaAlF$_6$ single crystal has a favorable chemical stability, and in normal use, almost no performance deterioration in a short period of time occurs. Furthermore, the Ce-containing LiCaAlF$_6$ single crystal has favorable mechanical strength and workability, and can easily be processed into a desired shape for use.

The method for manufacturing a Ce-containing LiCaAlF$_6$ single crystal is not limited, and a Ce-containing LiCaAlF$_6$ single crystal can be manufactured by a known single crystal manufacturing method, but preferably manufactured by the Czochralski method or the micro-pulling-down method. Employment of the Czochralski method or the micro-pulling-down method enables manufacture of a Ce-containing LiCaAlF$_6$ single crystal having excellent product qualities such as transparency. With the micro-pulling-down method, a single crystal can directly be manufactured into a particular shape and in addition, can be manufactured in a short period of time. Meanwhile, with the Czochralski method, a large-size single crystal having a diameter of several inches can be manufactured at a low cost.

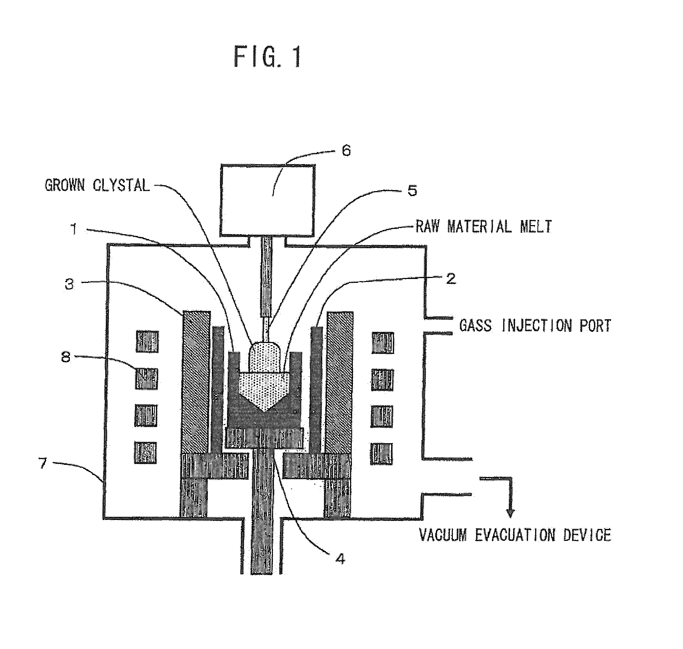

A general method for manufacturing a Ce-containing LiCaAlF$_6$ single crystal by means of the Czochralski method will be described below with reference to Figure 1.

First, a predetermined amount of raw materials is charged into a crucible 1. A purity of the raw materials is not specifically limited, but is preferably no less than 99.99%. Use of such admixture raw material with a high purity enables enhancement in purity of an obtained crystal, and thus, characteristics such as emission intensity of the obtained crystal are enhanced. For the raw materials, powdered or granular raw materials may be used, and the raw materials may be used after being sintered or melt and solidified in advance.

For the raw materials, metal fluorides, LiF, CaF$_2$, AlF$_3$ and CeF$_3$, are used.

Where a Ce-containing LiCaAlF$_6$ single crystal is manufactured by means of a melt growth method such as the Czochralski method, for a mixture ratio of these raw materials, LiF, CaF$_2$ and AlF$_3$, are weighed out to achieve a molar ratio of 1:1:1. However, since LiF and AlF$_3$ are easily volatilized, LiF and AlF$_3$ may be weighed respectively with an increase of around 1 to 10 mol%. The volatilized amounts completely differ depending on the crystal growth conditions (the temperature, the atmosphere and the process), and thus, it is desirable to find out volatilization amounts of LiF and AlF$_3$ in advance to determine weighing values. Also, where the raw materials are retained at a temperature at which volatilization easily occurs for a long period of time during the crystal growth, it is sometime necessary to weigh out LiF and AlF$_3$ with an increase of more than 10 mol%. Volatilization of CaF$_2$ and CeF$_3$ poses little problem under the normal growth conditions of an LiCaAlF$_6$ single crystal.

For the amount of CeF$_3$, the mixture ratio of the raw materials is determined using the effective segregation coefficient as described above, and taking a segregation phenomenon of Ce into account.

Next, the crucible 1 with the raw materials charged therein, a heater 2, a heat insulating material 3 and a movable stage 4 are set as illustrated in Figure 1. On the crucible 1, another crucible with a hole in a bottom portion thereof may be installed and hung by being fixed to, e.g., the heater 2 to provide a double crucible structure.

Also, a seed crystal 5 is attached to an end of an automatic diameter control device 6.

Although for the seed crystal, a metal having a high melting point such as platinum may be used, use of an LiCaAlF$_6$ single crystal or a single crystal having a crystal structure close to that of an LiCaAlF$_6$ single crystal enables easy growth of a crystal with favorable crystallinity. For example, an LiCaAlF$_6$ single crystal obtained as a result of cutting, grinding and polishing so as to have a rectangular parallelepiped shape with a size of around 6 x 6 x 30 mm$^3$ and make the side of 30 mm extend along a c-axis direction can be used.

The automatic diameter control device is a device capable of measuring a total weight of a seed crystal and a grown crystal, and adjusts a speed of pulling the seed crystal based on that information to control a diameter of the grown crystal, and a load cell for a pulling device, which is commercially available for crystal growth in the Czochralski method, can be used.

Next, the inside of the chamber 7 is vacuum-evacuated to no more than 1.0 x 10$^{-3}$ Pa using a vacuum evacuation device, and then, an inert gas such as high-purity argon is introduced into the chamber for gas replacement. A pressure inside the chamber after the gas replacement is not specifically limited, but is generally an atmospheric pressure. As a result of this gas replacement operation, moisture adhering to the raw material or the inside of the chamber can be removed, preventing deterioration of the crystal due to such moisture.

In order to avoid an adverse effect of moisture that cannot be removed even by the above gas replacement operation, it is preferable to use a solid scavenger such as zinc fluoride or a gaseous scavenger such as tetrafluoromethane. Where a solid scavenger is used, it is preferable to employ a method in which the solid scavenger is mixed in the raw materials in advance, and where a gaseous scavenger is used, it is preferable to employ a method in which the gaseous scavenger is mixed in the above inert gas and introduced into the chamber.

After the gas replacement operation is performed, the raw materials are heated and melt by a high frequency coil 8 and the heater 2. The heating method is not specifically limited, and for example, a resistance heating-type carbon heater can be used as appropriate instead of a combination of the high frequency coil and the heater.

Next, the molten raw material melt is brought into contact with the seed crystal. The output of the heater is adjusted to provide a temperature at which the part of the molten raw material melt that is in contact with the seed crystal is coagulated, and under the control of the automatic diameter control device 6, the resulting crystal is pulled while the pulling speed is automatically adjusted. During the growth, the movable stage 4 may be moved vertically as appropriate for liquid level adjustment. The crystal is consecutively pulled while the output of the high frequency coil is adjusted as appropriate, and when a desired length is reached, the crystal is cut out of the liquid surface and cooled over a sufficient period of time during which no cracking occurs in the grown crystal, whereby a single crystal of Ce-containing LiCaAlF$_6$ can be obtained.

In order to remove a deficit of fluorine atoms or defects in the crystal resulting from thermal strain, the grown crystal may be subjected to annealing.

The obtained Ce-containing LiCaAlF$_6$ single crystal is processed into a desired shape for use. For the processing, a known cutting machine, such as a blade saw or wire saw, a grinding machine or a lapping machine can be used without any limitation.

A neutron radiation detection scintillator according to the present invention can serve as a neutron radiation detector in combination with a photodetector such as a photomultiplier tube or a silicon photodiode. Light emitted from the neutron radiation detection scintillator according to the present invention has wavelengths of approximately 290 to 310 nm, and thus, a photodetector capable of detecting light in such region can preferably be used. In such type of photodetectors, specific examples of the photomultiplier tube include H6612, R7600U and H7416 manufactured by Hamamatsu Photonics K.K.

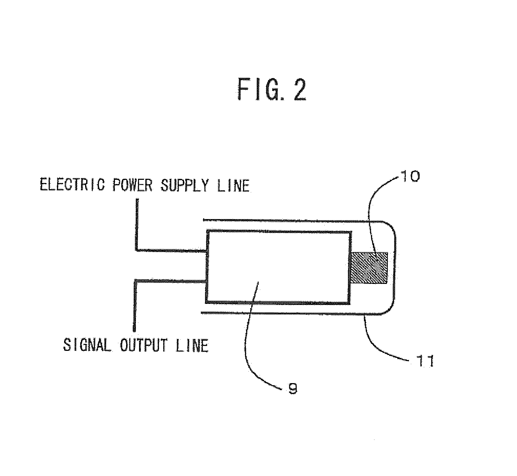

Figure 2 illustrates an example combination of a neutron radiation detection scintillator and a photomultiplier tube according to the present invention.

The combination is used by adhering a Ce-containing LiCaAlF$_6$ single crystal as a neutron radiation detection scintillator 10 to a photo-cathode window of a photomultiplier tube 9 via, e.g., an optical grease, shielding the single crystal from external light by means of a light-blocking material 11, and applying a high voltage to the photomultiplier tube.

For the photodetector, it is also possible to provide a neutron radiation imaging device by using a position-sensitive photomultiplier tube with an array of detection units each including a sensitive region of a several millimeter cube and bonding a Ce-containing LiCaAlF$_6$ single crystal having a size covering a part or entirety of the photo-cathode window to the position-sensitive photomultiplier tube.

For the position-sensitive photomultiplier tube, one capable of detecting light with wavelengths of approximately 290 to 310 nm, which is scintillation light emitted from a scintillator according to the present invention (for example, XP85012 manufactured by Photonis USA Inc.) is used. For bonding between the photo-cathode window and the crystal, e.g., an optical grease is used. The crystal may have an arbitrary shape, and may configure a scintillator array in which plate-like, blockish or quadrangular prism crystals are orderly arranged.

Furthermore, it is preferable that surfaces other than the neutron radiation incident surface of the photomultiplier tube are covered by, e.g., a cadmium plate or an LiF block to prevent entrance of neutron radiation from the periphery of the photomultiplier tube.

Here, an electric signal of a current or a voltage output according to an amount of light emitted from a neutron radiation detection scintillator as a result of neutron radiation irradiation and received by a photodetector such as a photomultiplier tube is referred to as a photodetection signal. Also, a pulse shape of a photodetection signal is a peak shape from occurrence of light emission to decay thereof in a graph with time plotted on the abscissa axis and the magnitude of the signal plotted on the ordinate axis.

A largest characteristic of the present invention lies in that photodetection signals obtained from a Ce-containing $LiCaAlF_6$ single crystal are discriminated as to whether the photodetection signals result from light emission caused by neutron radiation or light emission caused by $\gamma$ radiation, based on a difference in pulse shape according to a difference in period of decay between the light emissions. In other words, neutron radiation and $\gamma$ radiation are discriminated from each other utilizing the fact that decay time of light emission caused by neutron radiation is longer than decay time of light emission caused by $\gamma$ radiation.

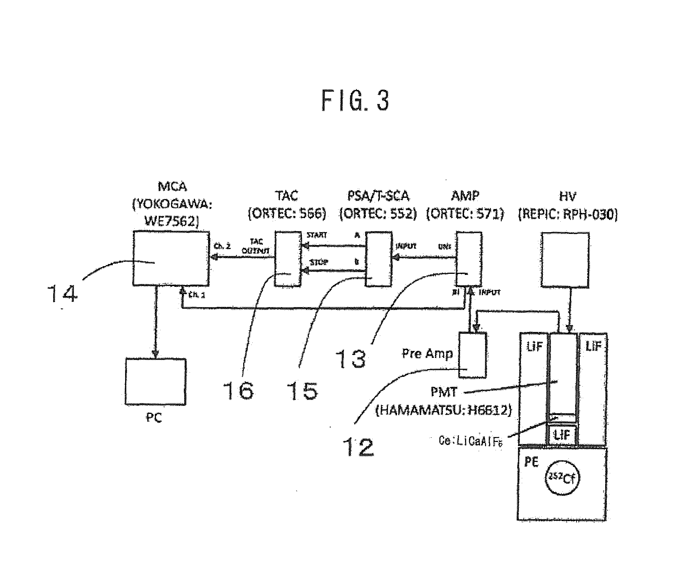

In pulse shape discrimination of photodetection signals, it is only necessary that photodetection signals be discriminated based on a difference in pulse shapes therebetween, and thus, there are no specific limitations in the method. For example, pulse shape discrimination of photodetection signals can be performed as follows with a system configuration such as illustrated in Figure 3.

Each photodetection signal is input to a main amplifier 13 via a preamplifier 12, which is illustrated in Figure 3, for amplification and shaping. One of signal outputs from the main amplifier 13 is input to an input terminal Ch.1 of a multi-parameter multi-channel analyzer (hereinafter also referred to as "multi-parameter MCA") 14 for use in signal pulse height measurement.

Another signal output from the main amplifier is input to a pulse shaping analyzer 15. The pulse shaping analyzer 15 integrates the amplified and shaped photodetection signal and outputs a logic signal when 10% and 90% of a signal pulse height of the integrated signal are reached, respectively. In this case, the timings for the outputs are not necessarily the times when 10% and 90% are reached, and it is possible to output logic signals at stages of a relatively low pulse height and a relatively high pulse height, and adjust the timings for outputs while finding out whether or not pulse shapes of light emissions caused by neutron radiation and $\gamma$ radiation can be discriminated, to determine the timings.

Next, the two logic signals output from the pulse shaping analyzer 15 are input to a time difference-to-pulse height converter 16, and a difference in time between the two logic signals output from the pulse shaping analyzer 15 is converted into a channel number and output. The channel number is determined as "rise time" and then is input to an input terminal Ch. 2 of the multi-parameter MCA 14 and a rise time distribution is measured.

For data in the multi-parameter MCA 14, time stamps (times of inputs of signals to Ch.1 and Ch.2) and pulse heights are stored in the form of text data. The time stamps of respective events of data from the input terminal Ch.1 and data from the input terminal Ch.2 are compared with each other, and only events within 10 microseconds are handled as signals corresponding to neutron radiation and $\gamma$ radiation from a radiation source.

Information output from the multi-parameter MCA 14, which is obtained as described above, can be input to a personal computer for analysis. Since with a Ce-containing $LiCaAlF_6$ single crystal, a value of rise time of light emission caused by neutron radiation is large, and thus, setting of a threshold value for rise times enables discrimination between light emissions caused by neutron radiation excitation and $\gamma$ radiation excitation.

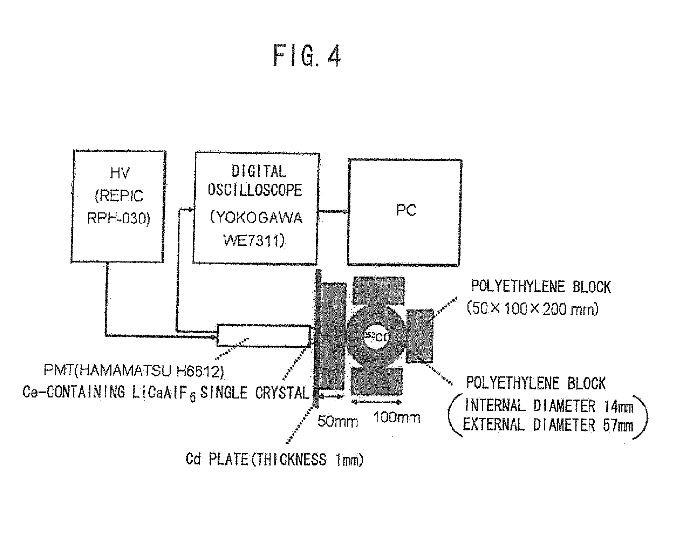

In pulse shape discrimination of photodetection signals, it is only necessary that photodetection signals be discriminated based on a difference in pulse shape therebetween, and the pulse shape discrimination can also be performed not only by the above-described analog circuit but also by digital pulse shape processing in a system configuration such as illustrated in Figure 4. Next, a method for discrimination by means of digital pulse shape processing will be described.

Photodetection signals obtained from a photomultiplier tube with the above-described Ce-containing $LiCaAlF_6$ single crystal bonded thereto are subjected to analog-digital conversion via a digital oscilloscope, and digital pulse shape data obtained as a result of the conversion are loaded into a personal computer.

The digital pulse shape data loaded into the personal computer can be analyzed using an arbitrary analysis program. For a method for discriminating between pulse shapes based on a difference in fluorescence lifetime, a method in which values of (fast component light emission amount)/(total light emission amount) are calculated and compared can be employed. The total light emission amount is a value of integral of an entire pulse shape from occurrence of light emission to light extinction, and an integral range of the fast component light emission amount is set to be narrower than an integral range of the total light emission amount. Since pulse shapes obtained as a result of measurement results may vary depending on the system configuration, it is desirable that the values of integral range experimentally be checked and adjusted before measurements. Where the time of start of occurrence of light emission is 0 seconds, the integral range of the total light emission amount may be, for example, around 0 to 10 microseconds. The fast component light emission amount is one based on light emission with a short fluorescence lifetime, and the integral range thereof may also be experimentally checked and adjusted before a measurement, and for a value of integral of pulse shape from occurrence of light emission to a time after a lapse of a relatively short period of time, for example, the integral range may be around 0 to 1 nanoseconds where a time of start of occurrence of light emission is 0 seconds.

Since a Ce-containing LiCaAlF$_6$ single crystal provides a long fluorescence lifetime of light emission caused by neutron radiation and a short fluorescence lifetime of light emission caused by $\gamma$ radiation, pulse shapes can be discriminated by considering a pulse shape having a large (fast component light emission amount) / (total light emission amount) value as a pulse shape originating from $\gamma$ radiation and a pulse shape having a small (fast component light emission amount) / (total light emission amount) value as a pulse shape originating from neutron radiation. A threshold value for determining whether the (fast component light emission amount) / (total light emission amount) value is large or small varies depending on, e.g., the type of the photomultiplier tube, and thus, desirably adjusted depending on the respective measurement system. For a method for determining the threshold value, for example, the threshold value can visually be determined using a graph of statistics distribution with (fast component light emission amount) / (total light emission amount) on the ordinate axis and (total light emission amount) on the abscissa axis. When such graph is drawn in a detector including a Ce-containing LiCaAlF$_6$ single crystal according to the present invention, several indefinite-form data groups can be observed. From among such data groups, pulse shapes belonging to a data group having a smallest (fast component light emission amount) / (total light emission amount) value are considered as being of a photodetection signal originating from neutron radiation and pulse shapes belonging to the other data groups are considered as being of a photodetection signal originating from $\gamma$ radiation, thereby setting the threshold value.

Determining pulse shapes with a (fast component light emission amount) /(total light emission amount) value below the set threshold value as being of a photodetection signal originating from neutron radiation and pulse shapes with the value exceeding the threshold value as being of a photodetection signal originating from $\gamma$ radiation, a pulse height distribution with the light emission amount (value of integral of pulse shapes) on the abscissa axis and the frequency or the number of times (number of pulse shapes observed for each light emission amount) on the ordinate axis is prepared for each of neutron radiation and $\gamma$ radiation, enabling obtainment of measurement data detected with discrimination between neutron radiation and $\gamma$ radiation.

In the present invention, a scintillator using any of colquiriite-type fluoride single crystals other than the LiCaAlF$_6$ single crystal is similar to that using an LiCaAlF$_6$ single crystal in a point that neutron radiation and $\gamma$ radiation are discriminated from each other based on a difference in pulse shape between photodetection signals. Also, these colquiriite-type fluoride single crystals are different from the LiCaAlF$_6$ single crystal only in that elements for M$^1$ and M$^2$ are replaced, and is similar to the LiCaAlF$_6$ single crystal in basic configuration. Furthermore, such scintillator can be manufactured by the aforementioned method for manufacturing a Ce-containing LiCaAlF$_6$ single crystal in which CaF$_2$ and AlF$_3$ are replaced with fluorides of predetermined elements.

## **Examples**

The present invention will be specifically described below taking examples; however, the present invention is not limited in any way by these examples.

## Example 1

(Manufacture of neutron radiation detection scintillator)

A Ce-containing LiCaAlF$_6$ single crystal was manufactured using a single crystal manufacturing apparatus according to the Czochralski method, which is illustrated in Figure 1. For raw materials, high-purity fluoride powders of LiF, CaF$_2$, AlF$_3$ and CeF$_3$ with a purity of no less than 99.99% were used. For LiF, one with a $^6$Li content percentage of 95% was used. For the crucible 1, the heater 2 and the heat insulating material 3, those made of high-purity carbon were used.

First, 278.4 g of LiF, 811.8 g of CaF$_2$, 916.8 g of AlF$_3$ and 61.5 g of CeF$_3$ were weighed out, respectively, and thoroughly mixed, and the resulting mixture raw material was charged into the crucible 1. The crucible 1 with the raw materials charged therein was installed on the movable stage 4, and the heater 2 and the heat insulating material 3 were sequentially set around the crucible 1. Next, a seed crystal 5 was obtained by cutting, grinding and polishing an LiCaAlF$_6$ single crystal so as to have a rectangular parallelepiped shape with a size of 6 x 6 x 30 mm$^3$ and make the side of 30 mm extend along the c-axis direction, and attached to the end of the automatic diameter control device.

Using a vacuum evacuation device including an oil-sealed rotary pump and an oil-diffusion pump, the inside of the chamber 6 was vacuum-evacuated to 5.0 x $10^{-4}$ Pa, and then, a tetrafluoromethane-argon mixture gas was introduced into the chamber 7 to reach an atmospheric pressure for gas replacement.

A high-frequency current was applied to the high frequency coil 8 and the raw material was heated by induction heating to melt. The seed crystal 5 was moved so as to come in contact with a liquid surface of the molten raw material melt. The heater output was adjusted so as to provide a temperature at which a part of the raw material melt that is in contact with the seed crystal is coagulated, and then, under the control of the automatic diameter control device 6, the crystal was pulled up while the pulling speed was automatically adjusted to achieve a target diameter of 55 mm.

The movable stage 4 was moved as appropriate to make adjustment so that the liquid surface height is constant during the growth, and the crystal was successively pulled up while the output of the high frequency coil was adjusted as appropriate, and when the length of the crystal reached approximately 80 mm, the crystal was cut away from the liquid surface and cooled for approximately 48 hours, whereby a Ce-containing $LiCaAlF_6$ single crystal with a diameter of 55 mm and a length of approximately 80 mm was obtained.

The obtained crystal was cut by means of a wire saw including a diamond wire and subjected to grinding and mirror polishing to have a shape of 10 mm long, 10 mm wide and 1 mm thick, whereby a neutron radiation detection scintillator according to the present invention, which includes an $LiCaAlF_6$ single crystal with 0.06 mol% of Ce contained, was obtained.


(Pulse shape-based neutron radiation-$\gamma$ radiation discrimination 1)


Performance of a neutron radiation detection scintillator for discrimination between neutron radiation and $\gamma$ radiation based on a difference in pulse shape between photodetection signals was evaluated by the following method. Figure 3 is a schematic diagram of a system configuration.

For a neutron source, $^{252}Cf$ was used, and $^{252}Cf$ was installed in a polyethylene block with a thickness of approximately 50 mm to perform measurement.

As illustrated in Figure 2, the neutron radiation detection unit was obtained by using a Ce-containing $LiCaAlF_6$ single crystal as the neutron radiation detection scintillator 10 and bonding the Ce-containing $LiCaAlF_6$ single crystal to the photo-cathode window of the photomultiplier tube 9 via an optical grease. A polytetrafluoroethylene tape as a reflective material was wound on all of surfaces of the scintillator. Furthermore, the entire photomultiplier tube was covered by an aluminum foil as the light-blocking material 11. For the photomultiplier tube, H6612 manufactured by Hamamatsu Photonics K.K. was used, and output signals were photodetection signals.

An LiF plate was installed around the radiation source and the neutron radiation detection unit to perform measurement while suppressing entrance of neutron from the periphery. The LiF plate between a moderator and the scintillator was installed to relatively reduce an amount of neutron radiation relative to an amount of $\gamma$ radiation to form a neutron radiation-$\gamma$ radiation mixture field by means of $^{252}Cf$ (sealed radiation source that provides neutron radiation and an amount of $\gamma$ radiation that is small relative to that of the neutron radiation).

Each photodetection signal was input to the main amplifier 13 via the preamplifier 12. One of signal outputs of the main amplifier 13 was input to the input terminal Ch.1 of the multi-parameter MCA 14 for use in pulse height measurement.

Another signal output of the main amplifier was input to the pulse shaping analyzer 15. The pulse shaping analyzer 15 output a logic signal when 10% and 90% of the signal pulse height were reached, respectively.

The two logic signals output from the pulse shaping analyzer 15 were input to the time difference-to-pulse height converter 16 to convert a difference in time between the logic signals into a channel number, and the channel number was determined as "rise time" and then was input to the input terminal Ch.2 of the multi-parameter MCA 14, and a rise time distribution was measured.

For data in the multi-parameter MCA 14, time stamps and pulse heights were stored in the form of text data. The time stamps of respective events of the data from the input terminal Ch.1 and the input terminal Ch.2 were compared with each other, and only events within 10 microseconds were handled as signals corresponding to neutron radiation and $\gamma$ radiation from the radiation source.

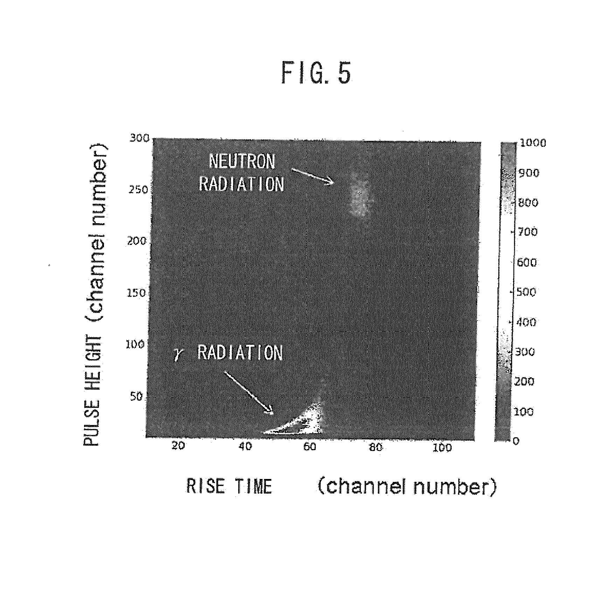

Figure 5 is a diagram of a distribution in which the rise times and the pulse heights in the data, which were obtained as described above, were two-dimensionally plotted.

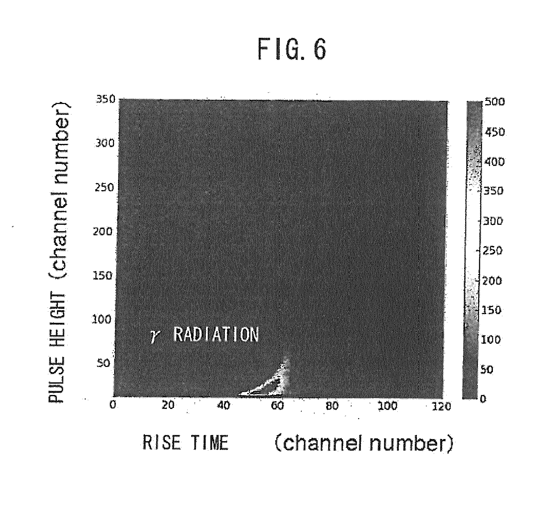

Also, Figure 6 is a diagram of a distribution in which rise times and pulse heights were two-dimensionally plotted where measurements were performed by a method similar to the above except the radiation source was changed to $^{137}Cs$, which is a sealed radiation source of $\gamma$ radiation and only $\gamma$ radiation was applied.

As a result, in Figure 5, light emission was observed in a region where the value of the rise time is large, and such light emission was not observed in Figure 6 where only $\gamma$ radiation was applied. Consequently, it can be seen that a region where the value of the rise time is large corresponds to an event of light emission caused by neutron radiation.

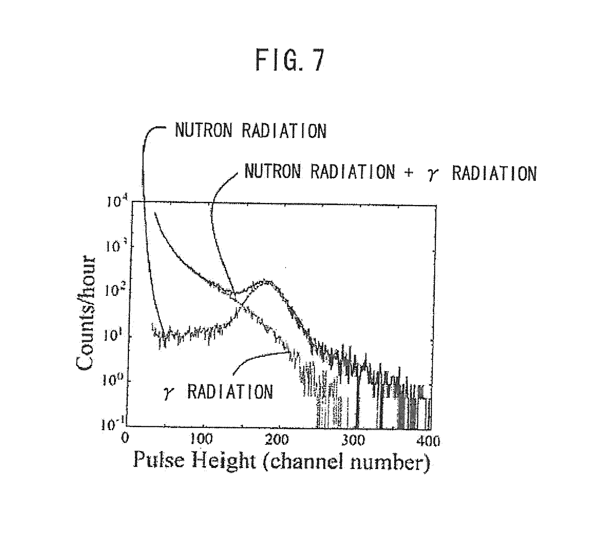

Also, Figure 7 illustrates a pulse height distribution in which unprocessed measurement data (neutron radiation + $\gamma$ radiation) are plotted and pulse height distributions in which measurement data resulting from light emission caused by neutron radiation and light emission caused by γ radiation being discriminated from each other and separated with a part of large pulse rise time values handled as that originating from neutron radiation are plotted. From these results, it can be seen that in a pulse height distribution of neutron radiation only, a peak has been separated from the backgrounds, resulting in success in pulse shape discrimination from γ radiation.

Comparative Example 1

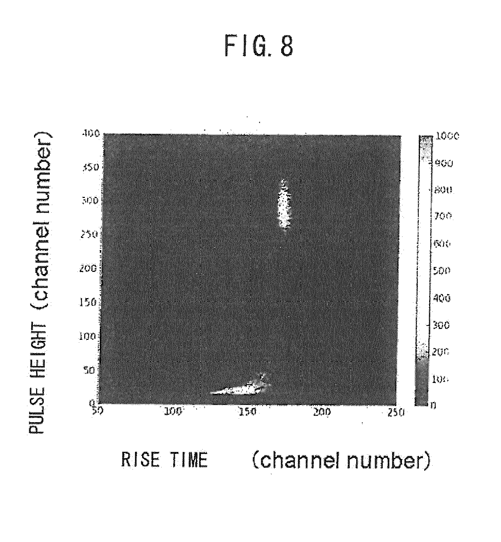

Using commercially-available lithium glass (GS20 manufactured by Saint-Gobain, K.K.) as a neutron radiation detection scintillator, pulse shape discrimination between neutron radiation and γ radiation was performed by means of a method similar to that of example 1. Figure 8 is a graph of a distribution in which rise times and pulse heights during neutron radiation irradiation by $^{252}$Cf are two-dimensionally plotted. Compared with Figure 5 in which similar measurement was performed using a Ce-containing LiCaAlF$_6$ single crystal as a neutron radiation detection scintillator, in the case of Figure 8, it can be seen that the difference in rise time (abscissa axis) between the neutron radiation and the γ radiation is small, resulting in difficulty in discrimination.

Example 2

(Pulse shape-based neutron radiation-γ radiation discrimination 2)

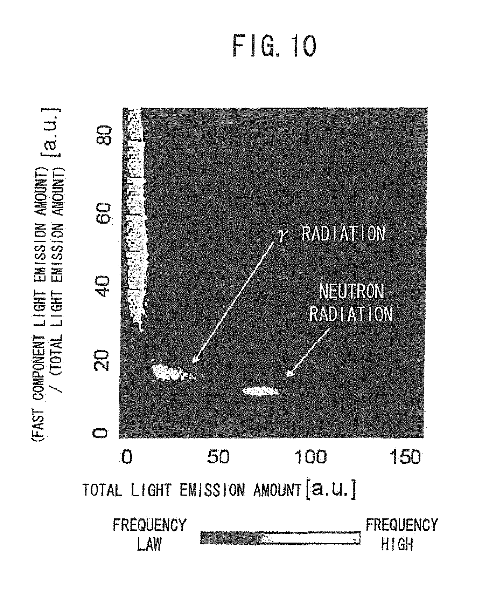

Next, the pulse shape discrimination using a Ce-containing LiCaAlF$_6$ single crystal, which was performed in example 1, was performed by means of digital pulse shape processing using a personal computer, rather than signal processing using an analog circuit.
Figure 4 is a schematic diagram of a system configuration. For a neutron source, $^{252}$Cf installed in a polyethylene block was used and a neutron radiation detection unit similar to that of example 1 was installed in the vicinity of the polyethylene. Furthermore, in order to reduce an amount of neutron radiation relative to an amount of γ radiation to form a neutron radiation-γ radiation mixture field by means of $^{252}$Cf, a Cd plate with a thickness of 1 mm was installed between a moderator and a scintillator. Photodetection signals from a photomultiplier tube were subjected to analog-digital conversion via a digital oscilloscope (WE7311 manufactured by Yokogawa Electric Corporation) and loaded into a personal computer.

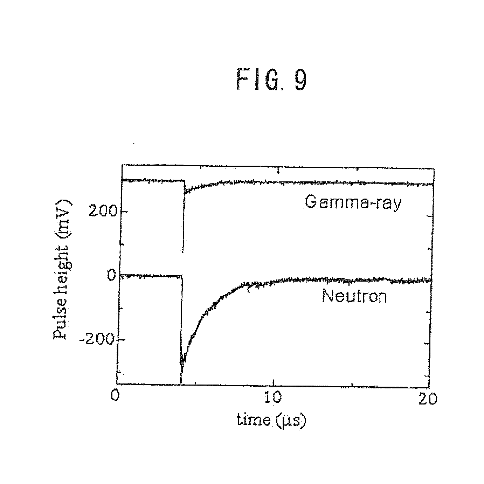

Figure 9 illustrates example pulse shapes of obtained photodetection signals. There were two types of pulse shapes: a pulse shape including fast light emission components and a pulse shape including no fast light emission components. As illustrated in Figure 6, where only γ radiation was applied by means of $^{137}$Cs, a rise time of a photodetection signal is short and thus, it can be seen that the pulse shape including fast light emission components is of a photodetection signal for light emission caused by γ radiation.
Digital pulse shape processing for determining whether or not the pulse shape is a pulse shape including fast light emission component was performed using the above-described method. An integral range of the total light emission amount is 0 to 10 microseconds where a time of start of occurrence of light emission is 0 seconds, and an integral range of the fast component light emission amount was 0 to 1 nanoseconds where the time of start of occurrence of light emission is 0 seconds. First, a two-dimensional plot with the calculated (fast component light emission amount) / (total light emission amount) value on the ordinate axis and the light emission amount on the abscissa axis was drawn as illustrated in Figure 10. From Figure 10, it can be seen that the obtained pulse shape data can visually be separated into several data groups. From among the data groups, an oval data group in which the value of (fast component light emission amount) / (total light emission amount) is small is regarded as a group of data originating from neutron radiation, and a threshold value (value of approximately 15 on the ordinate axis in Figure 10) was set. Values exceeding the threshold value were determined to be of photodetection signals originating from γ radiation, and values below the threshold value were determined to be of photodetection signals originating from neutron radiation.

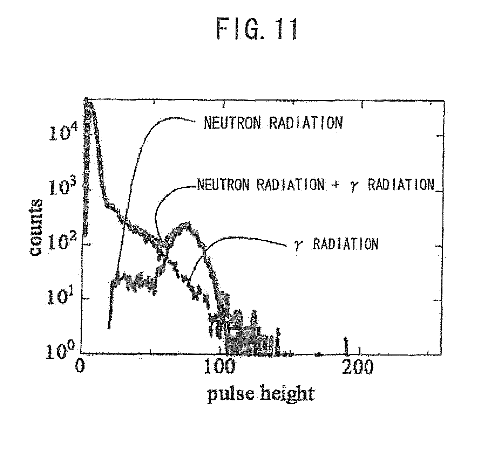

Figure 11 illustrates pulse height spectrums obtained by above described processing. In Figure 11, all of obtained measurement data (neutron radiation + γ radiation), measurement data of a photodetection signal originating from neutron radiation and measurement data of a photodetection signal originating from γ radiation, which were obtained by separating all of the obtained measurement data by means of the above-described digital pulse shape processing. As in Figure 7, which indicates results of pulse shape discrimination using an analog circuit, it can be seen that discrimination in pulse height spectrum between neutron radiation and γ radiation was successfully performed and thus neutron radiation and γ radiation can also be obtained with the neutron radiation and the γ radiation pulse shape discriminated from each other in a neutron radiation-γ radiation mixture field where digital pulse shape processing is used.
As described above, it can be seen that a detector including a Ce-containing LiCaAlF$_6$ single crystal and a pulse shape discrimination mechanism can detect neutron radiation and γ radiation with the neutron radiation and the γ radiation discriminated from each other.

**List of references**

| | |
|---|---|
| 1 | crucible |
| 2 | heater |
| 3 | heat insulating material |
| 4 | movable stage |
| 5 | seed crystal |
| 6 | automatic diameter control device |
| 7 | chamber |
| 8 | high frequency coil |
| 9 | photomultiplier tube |
| 10 | neutron radiation detection scintillator |
| 11 | light-blocking material |
| 12 | preamplifier |
| 13 | main amplifier |
| 14 | multi-parameter MCA |
| 15 | pulse shaping analyzer |
| 16 | time difference-to-pulse height converter |

**Claims**

1. A neutron radiation detector comprising:

   a neutron radiation detection scintillator including a single crystal of a Ce-containing compound represented by a formula, $LiM^1M^2F_6$ (wherein $M^1$ is at least one type of alkaline-earth metal element selected from Mg, Ca, Sr and Ba and $M^2$ is at least one type of metal element selected from Al, Sc, Ti, Cr, Fe and Ga); and
   a pulse shape discrimination device that discriminates between neutron radiation and $\gamma$ radiation based on a difference in pulse shape between photo detection signals from the neutron radiation detection scintillator.

2. The neutron radiation detector according to claim 1, wherein a neutron radiation detection scintillator including a Ce-containing $LiCaAlF_6$ single crystal is used as the neutron radiation detection scintillator.

3. The neutron radiation detector according to claim 1 or 2, wherein the pulse shape discrimination device discriminates between the neutron radiation and the $\gamma$ radiation based on the difference in pulse shape, the difference being determined according to a difference in period of decay between light emission caused by the neutron radiation and light emission caused by the $\gamma$ radiation.

4. A neutron radiation detection scintillator comprising a Ce-containing $LiCaAlF_6$ single crystal, wherein the neutron radiation detection scintillator discriminates between neutron radiation and $\gamma$ radiation based on a difference in pulse shape between photo detection signals.

5. A method for discriminating between neutron radiation and $\gamma$ radiation, the method comprising discriminating between neutron radiation and $\gamma$ radiation based on a difference in pulse shape between photo detection signals from a neutron radiation detection scintillator including a Ce-containing $LiCaAlF_6$ single crystal.

# FIG. 1

GROWN CLYSTAL

RAW MATERIAL MELT

GASS INJECTION PORT

VACUUM EVACUATION DEVICE

FIG. 2

ELECTRIC POWER SUPPLY LINE

10

SIGNAL OUTPUT LINE

11

9

# FIG. 3

FIG. 4

HV (REPIC RPH-030)

DIGITAL OSCILLOSCOPE (YOKOGAWA WE7311)

PC

POLYETHYLENE BLOCK (50×100×200 mm)

PMT(HAMAMATSU H6612)

Ce-CONTAINING LiCaAlF₆ SINGLE CRYSTAL

POLYETHYLENE BLOCK (INTERNAL DIAMETER 14mm / EXTERNAL DIAMETER 57mm)

50mm   100mm

Cd PLATE(THICKNESS 1mm)

## FIG. 5

FIG. 6

FIG. 7

FIG. 8

FIG. 9

FIG. 10

EP 2 573 590 A1

## FIG. 11

## INTERNATIONAL SEARCH REPORT

| | International application No. |
|---|---|
| | PCT/JP2011/061440 |

### A. CLASSIFICATION OF SUBJECT MATTER
*G01T3/06*(2006.01)i, *C09K11/00*(2006.01)i, *C09K11/64*(2006.01)i, *G01T1/17* (2006.01)i, *G01T3/00*(2006.01)i

According to International Patent Classification (IPC) or to both national classification and IPC

### B. FIELDS SEARCHED

Minimum documentation searched (classification system followed by classification symbols)
G01T3/06, C09K11/00, C09K11/64, G01T1/17, G01T3/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2009/119378 A1 (Tokuyama Corp.), 01 October 2009 (01.10.2009), paragraphs [0001], [0003] to [0004], [0006] to [0059]; fig. 1 to 4 & US 2010/0314550 A & EP 2256177 A & WO 2009/119378 A1 & CA 2717341 A | 1-5 |
| A | WO 2004/086089 A1 (Hokushin Corp.), 07 October 2004 (07.10.2004), entire text; all drawings & US 2006/0033025 A1 | 1-5 |

☐ Further documents are listed in the continuation of Box C.          ☐ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 01 June, 2011 (01.06.11) | 14 June, 2011 (14.06.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

26

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2009119378 A

### Non-patent literature cited in the description

- **S.D. JASTANIAH et al.** Digital techniques for $n/\gamma$ pulse shape discrimination and capture-gated neutron spectroscopy using liquid scintillators. *Nuclear Instruments and Methods in Physics Research A, Accelerators, Spectrometers, Detectors and Associated Equipment,* 2004, vol. 517, 202-210
- **C. W. E. VAN EIJK et al.** LiBaF3, a thermal neutron scintillator with optimal n-$\gamma$ discrimination. *Nuclear Instruments and Methods in Physics Research A,* 1996, vol. 374, 197-201
- **C. W. E. VAN EIJK et al.** Development of Elpasolite and Monoclinic Thermal Neutron Scintillators. *IEEE Nuclear Science Symposium Conference Record, N12-3,* 2005
- **KIYOSHI SHIMAMURA et al.** Growth of Ce-doped LiCaAlF6 and LiS-rAlF6 single crystals by the Czochralski technique under CF4 atmosphere. *Journal of Crystal Growth,* 2000, vol. 211, 302-307